# EUROPEAN PATENT APPLICATION

(11) **EP 4 583 163 A2**
(43) Date of publication of application: **09.07.2025**
(21) Application number: 24218507.2
(22) Date of filing: 09.12.2024
(51) Int. Cl.: H01L 25/18, H01L 25/00, H01L 21/02, H10B 43/20, H01L 25/065

(54) **METHOD OF MANUFACTURING SEMICONDUCTOR DEVICES**

(30) Priority: 14.12.2023 KR 20230182373
(71) Applicant: Samsung Electronics Co., Ltd., Suwon-si, Gyeonggi-do 16677 (KR)
(72) Inventor: KIM, Yeonsook, 16677 Suwon-si (KR); LEE, Junga, 16677 Suwon-si (KR); KIM, Yechan, 16677 Suwon-si (KR); JUNG, Wooseung, 16677 Suwon-si (KR)
(74) Representative: Marks & Clerk LLP

(57) **Abstract**

A method of manufacturing a semiconductor device includes forming a memory stack on a cell wafer, the cell wafer having a first crystal orientation and including a silicon single crystal wafer and a first notch, forming a peripheral circuit stack on a peripheral circuit wafer, the peripheral circuit wafer including a silicon single crystal wafer and having a second crystal orientation different from the first crystal orientation, and bonding the cell wafer to the peripheral circuit wafer such that the memory stack and the peripheral circuit stack come into contact with each other, wherein the first crystal orientation is expressed as {first surface orientation}<first notch direction>, and the first crystal orientation includes any one of {110}<100>, {110}<112>, {111}<110>, and {111}<112>.

## Description

### BACKGROUND

In electronic systems that include data storage, semiconductor devices capable of storing large amounts of data may be desirable. As one method for increasing the data storage capacities of the semiconductor devices, semiconductor devices including three-dimensionally arranged memory cells instead of two-dimensionally arranged memory cells have been proposed. Also, semiconductor devices manufactured by forming a part of a semiconductor device on a first substrate, forming another part of the semiconductor device on a second substrate, and bonding the first substrate and the second substrate to each other have been proposed.

### SUMMARY

Some implementations according to this disclosure relate to methods of manufacturing bonding-type 3-dimensional memory devices.

Some implementations provide a semiconductor device capable of exhibiting reduced defects due to warpage of a substrate during a bonding process.

According to some implementations, there is provided a method of manufacturing a semiconductor device, the method including forming a memory stack on a cell wafer, wherein the cell wafer has a first crystal orientation and includes a silicon single crystal wafer, a first upper surface, and a first notch formed to a certain depth in a direction from an outer circumference of the cell wafer toward a central region of the cell wafer, forming a peripheral circuit stack on a peripheral circuit wafer, wherein the peripheral circuit wafer includes a silicon single crystal wafer and has a second crystal orientation different from the first crystal orientation, and bonding the cell wafer to the peripheral circuit wafer such that the memory stack and the peripheral circuit stack come into contact with each other, wherein the first crystal orientation is defined by a first surface orientation and a first notch direction, wherein the first surface orientation is defined based on the first upper surface of the cell wafer in a direction perpendicular to the first upper surface of the cell wafer, and the first notch direction is defined based on a direction from the central region of the cell wafer toward the first notch of the cell wafer, wherein the first crystal orientation is expressed as {the first surface orientation}<the first notch direction>, and the first crystal orientation includes any one of {110} <100>, { 110}<112>, {111}<110>, and {111}<112>.

According to some implementations, there is provided a method of manufacturing a semiconductor device, the method including forming a memory stack on a cell wafer, wherein the cell wafer has a first crystal orientation and includes a silicon single crystal wafer, a first upper surface, and a first notch formed to a certain depth in a direction from an outer circumference of the cell wafer toward a central region of the cell wafer, forming a peripheral circuit stack on a peripheral circuit wafer, wherein the peripheral circuit wafer has a second crystal orientation different from the first crystal orientation and includes a silicon single crystal wafer, a second upper surface, and a second notch formed to a certain depth in a direction from an outer circumference of the peripheral circuit wafer toward a central region of the peripheral circuit wafer, and the peripheral circuit wafer, and bonding the cell wafer to the peripheral circuit wafer such that the memory stack and the peripheral circuit stack come into contact with each other, wherein the first crystal orientation is defined by a first surface orientation and a first notch direction, wherein the first surface orientation is defined based on the first upper surface of the cell wafer in a direction perpendicular to the first upper surface of the cell wafer, and the first notch direction is defined based on a direction from the central region of the cell wafer toward the first notch of the cell wafer, wherein the first crystal orientation is expressed as {the first surface orientation}<the first notch direction>, and the first crystal orientation includes {110}<100> or {110}<112>, wherein the second crystal orientation is defined by a second surface orientation and a second notch direction, wherein the second surface orientation is defined based on a direction perpendicular to the second upper surface of the peripheral circuit wafer above the second upper surface of the peripheral circuit wafer, and the second notch direction is defined based on a direction from the central region of the peripheral circuit wafer toward the second notch of the peripheral circuit wafer, wherein the second crystal orientation is expressed as {the second surface orientation}<the second notch direction>, and the second crystal orientation includes {100}<100> or {100}<110>.

According to some implementations, there is provided a method of manufacturing a semiconductor device, the method including providing a cell wafer having a first crystal orientation and including a silicon single crystal wafer, a first upper surface, and a first notch formed to a certain depth in a direction from an outer circumference of the cell wafer toward a central region of the cell wafer, wherein the first crystal orientation is defined by a first surface orientation and a first notch direction, wherein the first surface orientation is defined based on the first upper surface of the cell wafer in a direction perpendicular to the first upper surface of the cell wafer, and the first notch direction is defined based on a direction from the central region of the cell wafer toward the first notch of the cell wafer, wherein the first crystal orientation is expressed as {the first surface orientation}<the first notch direction>, and the first crystal orientation includes any one of {110}<100>, {110}<112>, {111}<110>, and {111}<112>, forming a memory stack on the cell wafer, wherein the memory stack includes a plurality of gate electrodes extending in a first horizontal direction and spaced apart from each other in a vertical direction and a plurality of channels each extending in the vertical direction while passing through the plurality of gate electrodes, providing a peripheral circuit wafer having a second crystal orientation different from the first crystal orientation and including a silicon single crystal wafer, a second upper surface, and a second notch formed to a certain depth in a direction from an outer circumference of the peripheral circuit wafer toward a central region of the peripheral circuit wafer, forming, on the peripheral circuit wafer, a peripheral circuit stack including a peripheral circuit, and bonding the cell wafer to the peripheral circuit wafer such that the memory stack and the peripheral circuit stack come into contact with each other.

At least some of the above and other features of the invention are set out in the claims.

### BRIEF DESCRIPTION OF THE DRAWINGS

Implementations will be more clearly understood from the following detailed description taken in conjunction with the accompanying drawings in which:
FIG. 1 is a flowchart showing a method of manufacturing a semiconductor device, according to some implementations;
FIGS. 2A, 2B, 3A, 3B, 4A, 4B, and 5 to 7 are schematic views showing a method of manufacturing a semiconductor device, according to some implementations;
FIGS. 8A, 8B, 9A, and 9B are graphs showing warpage characteristics;
FIG. 10 is a graph showing simulation results of warpage values;
FIGS. 11A and 11B are graphs showing warpage characteristics; and
FIGS. 12A, 12B, 13A, 13B, 14A, 14B, and 15 to 20 are schematic views showing a method of manufacturing a semiconductor device, according to some implementations.

### DETAILED DESCRIPTION

Hereinafter, examples are described in detail with reference to the accompanying drawings.

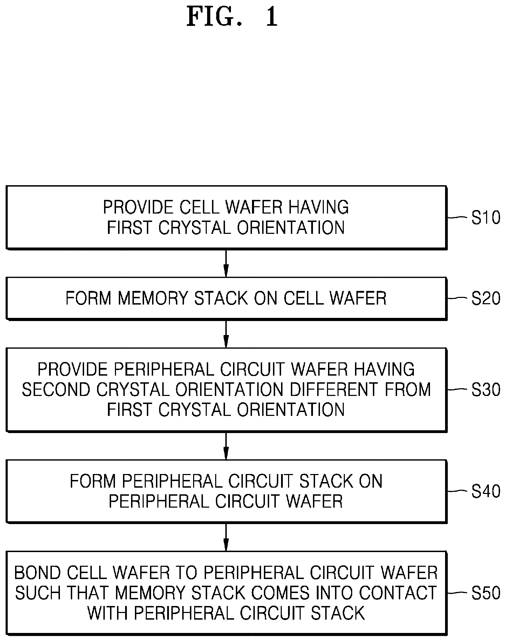

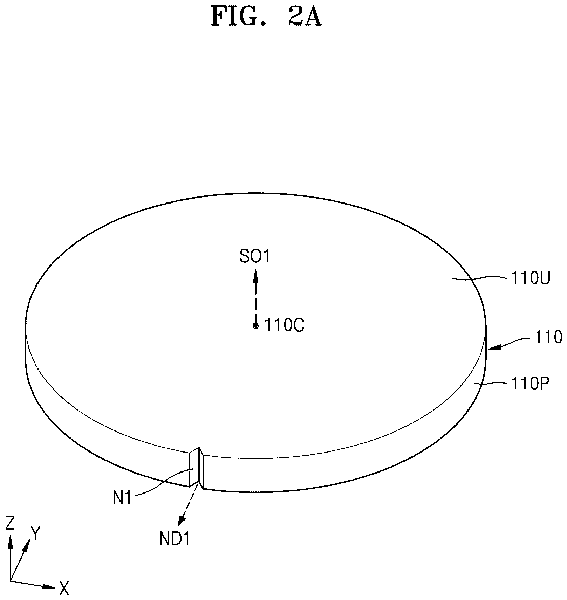

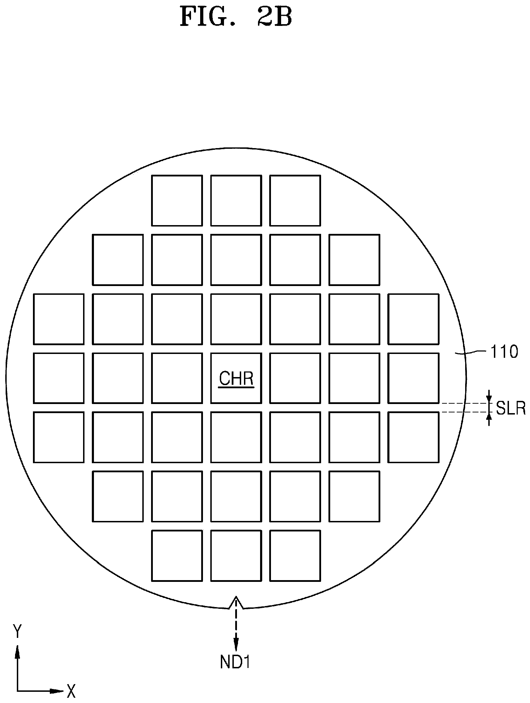

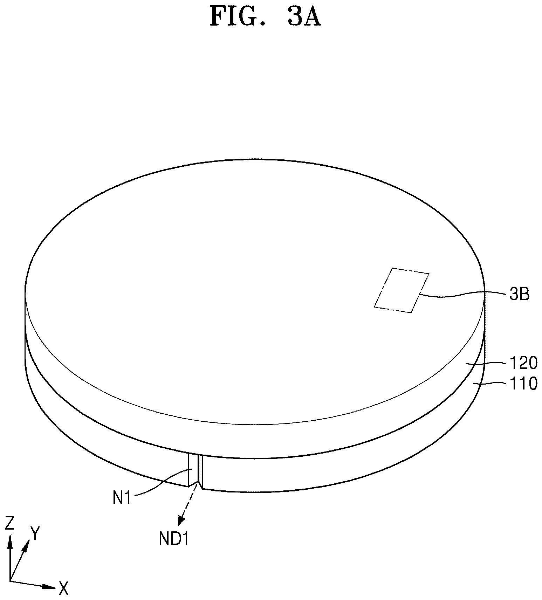

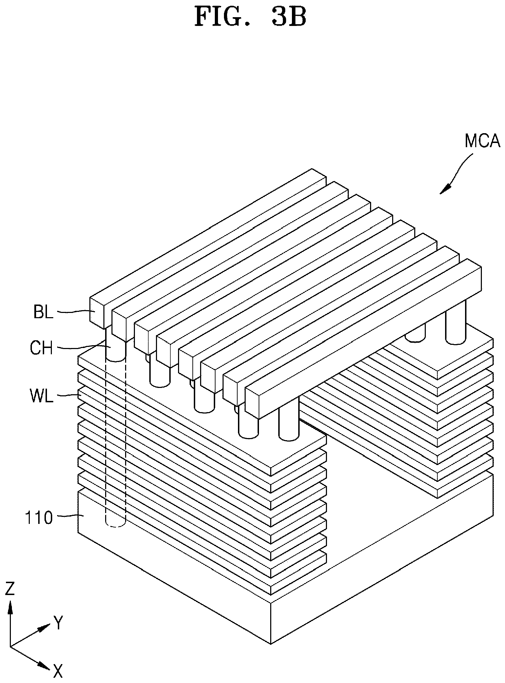

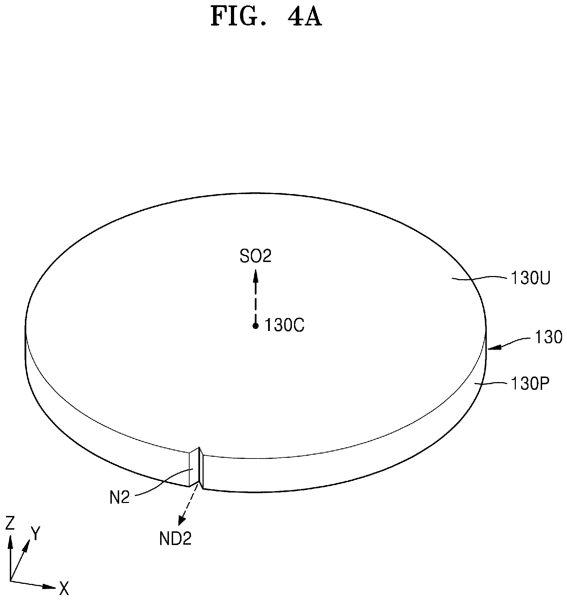

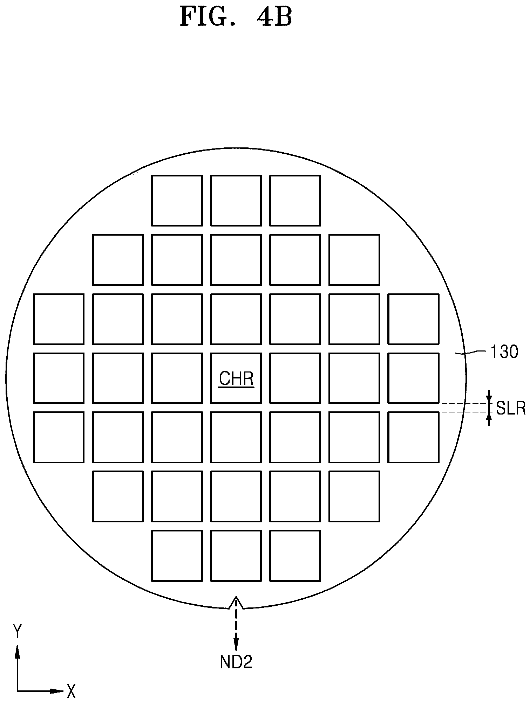

FIG. 1 is a flowchart showing a method of manufacturing a semiconductor device, according to some implementations. FIGS. 2A, 2B, 3A, 3B, 4A, 4B, and 5 to 7 are schematic views showing a method of manufacturing a semiconductor device, for example, the method illustrated in FIG. 1. Specifically, FIG. 2B is a plan view of FIG. 2A, FIG. 3B is an enlarged view of region 3B of FIG. 3A, and FIG. 4B is a plan view of FIG. 4A.

Referring to FIGS. 1, 2A, and 2B, a cell wafer 110 is provided (S10).

The cell wafer 110 may include a semiconductor single crystal wafer. For example, the cell wafer 110 may include at least one of a silicon single crystal wafer, a germanium single crystal wafer, and a silicon germanium single crystal wafer. In some implementations, the cell wafer 110 may include the silicon single crystal wafer. A semiconductor single crystal wafer may be a wafer having a single crystal structure. For instance, a semiconductor single crystal wafer may have a single continuous crystal lattice structure. The semiconductor single crystal wafer may be free of grain boundaries.

The cell wafer 110 may include a first upper surface 110U and an outer circumference 110P and may also include a first notch N1 defined in the outer circumference 110P of the cell wafer 110. The first notch N1 may be formed to a certain depth in a direction from the outer circumference 110P of the cell wafer 110 toward a central region 110C (e.g., a center) of the cell wafer 110. The first notch N1 may be provided to align the cell wafer 110 during the manufacturing process of the cell wafer 110.

The cell wafer 110 may have a first crystal orientation. The first crystal orientation may be defined by a first surface orientation SO1 and a first notch direction ND1. The first surface orientation SO1 may be defined based on the first upper surface 110U of the cell wafer 110, e.g., in the direction perpendicular to the first upper surface 110U. The first surface orientation SO1 may correspond to a crystal plane index or a Miller index of the first upper surface 110U. The first notch direction ND1 may be defined based on the direction from the central region 110C toward the first notch N1 of the cell wafer 110.

The first upper surface 110U of the cell wafer 110 may extend in a first horizontal direction X and a second horizontal direction Y, and the direction perpendicular to the first upper surface 110U may be parallel to a vertical direction Z. A first notch direction ND1 of the first notch N1 may be parallel to the second horizontal direction Y. It will be appreciated that the directions discussed herein are defined relative to the structure of the cell wafer 110. Accordingly, whilst the terms "vertical" and "horizontal" are used, these terms are relative to the structure of the cell wafer 110, and therefore need not imply any particular orientation of the cell wafer 110 during manufacture.

The first crystal orientation is defined by the first surface orientation SO1 and the first notch direction ND1 and may be expressed as {first surface orientation} <first notch direction>. In some implementations, the first crystal orientation of the cell wafer 110 may include any one of {110}<100>, {110}<112>, {111}<110>, and {111}<112>. For instance, the first upper surface 110U may be parallel to a crystallographic plane (e.g. {110} or {111}) of the silicon single crystal. For instance, the first notch direction ND1 may be parallel to a crystallographic direction (e.g. <100> or <112>) of the cell wafer 110.

In some implementations, the first crystal orientation of the cell wafer 110 may include {110}<100>. The first upper surface 110U may be arranged parallel to the crystallographic {110} plane of the silicon single crystal, and the first notch direction ND1 may be parallel to the crystallographic <100> direction of the silicon single crystal. In some implementations, the first crystal orientation of the cell wafer 110 may include {110}<112>. The first upper surface 110U may be arranged parallel to the crystallographic {110} plane of the silicon single crystal, and the first notch direction ND1 may be parallel to the crystallographic <112> direction of the silicon single crystal.

In some implementations, the first crystal orientation of the cell wafer 110 may include {111}<110>. The first upper surface 110U may be arranged parallel to the crystallographic {111} plane of the silicon single crystal, and the first notch direction ND1 may be parallel to the crystallographic <110> direction of the silicon single crystal. In some implementations, the first crystal orientation of the cell wafer 110 may include {111 }<112>. The first upper surface 110U may be arranged parallel to the crystallographic {111} plane of the silicon single crystal, and the first notch direction ND1 may be parallel to the crystallographic <112> direction of the silicon single crystal.

In some implementations, the cell wafer 110 may have a thickness of about 750 micrometers to about 840 micrometers. For instance, the cell wafer 110 may have a thickness falling in the range of 750 micrometers to 840 micrometers. The thickness may be measured in the vertical direction Z.

In some implementations, as shown in FIG. 2B, the cell wafer 110 may include a plurality of chip formation regions CHR. The plurality of chip formation regions CHR may be spaced apart from each other with scribe lane regions SLR therebetween. The plurality of chip formation regions CHR may include regions on which semiconductor devices are formed in subsequent processes, and the scribe lane regions SLR may include regions which are cut (e.g. sawed) to divide the semiconductor devices formed on the plurality of chip formation regions CHR into a plurality of individual semiconductor chips.

Referring to FIGS. 1, 3A, and 3B, a memory stack 120 is formed on the cell wafer 110 (S20).

In some implementations, the memory stack 120 may include a memory cell array MCA that includes a plurality of memory cells arranged in three dimensions. In some implementations, the memory cell array MCA may include flash memory cells and may include a 3-dimensional memory cell array. The 3-dimensional memory cell array may include a plurality of negative-AND (NAND) strings, and each of the NAND strings may include a plurality of memory cells arranged in the vertical direction Z above the cell wafer 110.

In some implementations, the memory cell array MCA may include a plurality of variable-resistance memory cells arranged in the vertical direction Z above the cell wafer 110. In some implementations, the memory cell array MCA may include a plurality of phase-change memory cells arranged in the vertical direction Z above the cell wafer 110. In some implementations, the memory cell array MCA may include a plurality of ferroelectric memory cells arranged in the vertical direction Z above the cell wafer 110.

In some implementations, the memory stack 120 may include a plurality of word lines WL disposed on the cell wafer 110, extending in the first horizontal direction X, and spaced apart from each other in the vertical direction Z and a plurality of channels CH extending in the vertical direction Z while passing through the plurality of word lines WL. Also, the memory stack 120 may include a plurality of bit lines BL respectively connected to the plurality of channels CH and extending in the second horizontal direction Y.

In some implementations, the number of word lines WL arranged in the vertical direction Z may be tens to hundreds, to provide non-limiting examples. When the number of word lines WL arranged in the vertical direction Z increases, the storage capacity of the memory cell array MCA may increase.

When the number of the plurality of word lines WL arranged in the vertical direction Z increases, anisotropy in terms of stress of the memory stack 120 may increase. For example, as the plurality of word lines WL extend in the first horizontal direction X, an imbalance may occur between stress components in the first horizontal direction X and stress components in the second horizontal direction Y. However, according to some implementations, the first crystal orientation of the cell wafer 110 includes one of {110}<100>, {110}<112>, {111}<110>, and {111}<112>, and, based on this crystal orientation, the stress anisotropy of the memory stack 120 disposed on the cell wafer 110 may be significantly reduced. Also, in some implementations, as the cell wafer 110 has the first crystal orientation and has a thickness of about 750 micrometers to about 840 micrometers, the stress anisotropy of the memory stack 120 disposed on the cell wafer 110 may be significantly reduced.

Referring to FIGS. 1, 4A, and 4B, a peripheral circuit wafer 130 is provided (S30).

The peripheral circuit wafer 130 may include a semiconductor single crystal wafer. For example, the peripheral circuit wafer 130 may include at least one of a silicon single crystal wafer, a germanium single crystal wafer, and a silicon germanium single crystal wafer. In some implementations, the peripheral circuit wafer 130 may include the silicon single crystal wafer.

The peripheral circuit wafer 130 may include a second upper surface 130U and an outer circumference 130P and may also include a second notch N2 defined in the outer circumference 130P of the peripheral circuit wafer 130. The second notch N2 may be formed to a certain depth in a direction from the outer circumference 130P of the peripheral circuit wafer 130 toward a central region 130C (e.g., a center) of the peripheral circuit wafer 130. The second notch N2 may be provided to align the peripheral circuit wafer 130 during the manufacturing process of the peripheral circuit wafer 130.

The peripheral circuit wafer 130 may have a second crystal orientation. The second crystal orientation may be different from the first crystal orientation. The second crystal orientation may be defined by a second surface orientation SO2 and a second notch direction ND2. The second surface orientation SO2 may be defined based on the second upper surface 130U of the peripheral circuit wafer 130 in the direction perpendicular to the second upper surface 130U. The second notch direction ND2 may be defined based on the direction from the central region 130C toward the second notch N2 of the peripheral circuit wafer 130.

The second upper surface 130U of the peripheral circuit wafer 130 may extend in a first horizontal direction X and a second horizontal direction Y, and the direction perpendicular to the second upper surface 130U may be parallel to a vertical direction Z. The second notch direction ND2 of the second notch N2 may be parallel to the second horizontal direction Y. It will be appreciated that the directions discussed herein are defined relative to the structure of the peripheral circuit wafer 130. Accordingly, whilst the terms "vertical" and "horizontal" are used, these terms are relative to the structure of the peripheral circuit wafer 130, and therefore need not imply any particular orientation of the peripheral circuit wafer 130 during manufacture.

The second crystal orientation is defined by the second surface orientation SO2 and the second notch direction ND2 and may be expressed as {second surface orientation}<second notch direction>. In some implementations, the second crystal orientation of the peripheral circuit wafer 130 may include {100}<100> or {100}<110>. For instance, the second upper surface 130U may be parallel to a crystallographic plane (e.g. {100}) of the silicon single crystal. For instance, the second notch direction ND2 may be parallel to a crystallographic direction (e.g. <100> or <110>) of the peripheral circuit wafer 130.

In some implementations, the second crystal orientation of the peripheral circuit wafer 130 may include {100}<100>. The second upper surface 130U may be arranged parallel to the crystallographic {100} plane of the silicon single crystal, and the second notch direction ND2 may be parallel to the crystallographic <100> direction of the silicon single crystal. In some implementations, the second crystal orientation of the peripheral circuit wafer 130 may include {100}<110>. The second upper surface 130U may be arranged parallel to the crystallographic {100} plane of the silicon single crystal, and the second notch direction ND2 may be parallel to the crystallographic <110> direction of the silicon single crystal.

In some implementations, the peripheral circuit wafer 130 may have a thickness of about 750 micrometers to about 840 micrometers. For instance, the peripheral circuit wafer 130 may have a thickness falling in the range of 750 micrometers to 840 micrometers. The thickness may be measured in the vertical direction Z.

In some implementations, as shown in FIG. 4B, the peripheral circuit wafer 130 may include a plurality of chip formation regions CHR. The plurality of chip formation regions CHR may be spaced apart from each other with scribe lane regions SLR therebetween. The plurality of chip formation regions CHR may include regions on which semiconductor devices are formed in subsequent processes, and the scribe lane regions SLR may include regions which are cut (e.g. sawed) to divide the semiconductor devices formed on the plurality of chip formation regions CHR into a plurality of individual semiconductor chips.

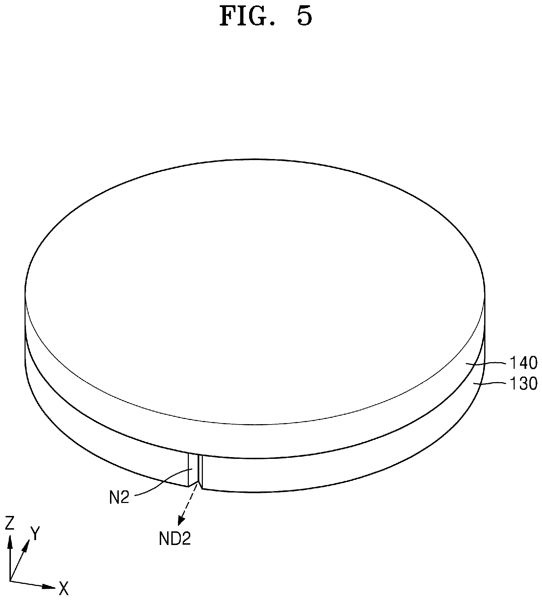

Referring to FIGS. 1 and 5, a peripheral circuit stack 140 is formed on the peripheral circuit wafer 130 (S40).

In some implementations, the peripheral circuit stack 140 may include a peripheral circuit. In some implementations, the peripheral circuit may include a row decoder, a page buffer, a data input/output circuit, and/or a control logic. In some implementations, the peripheral circuit may include an input/output interface, a column logic, a voltage generator, a pre-decoder, a temperature sensor, a command decoder, an address decoder, an amplifier circuit, etc.

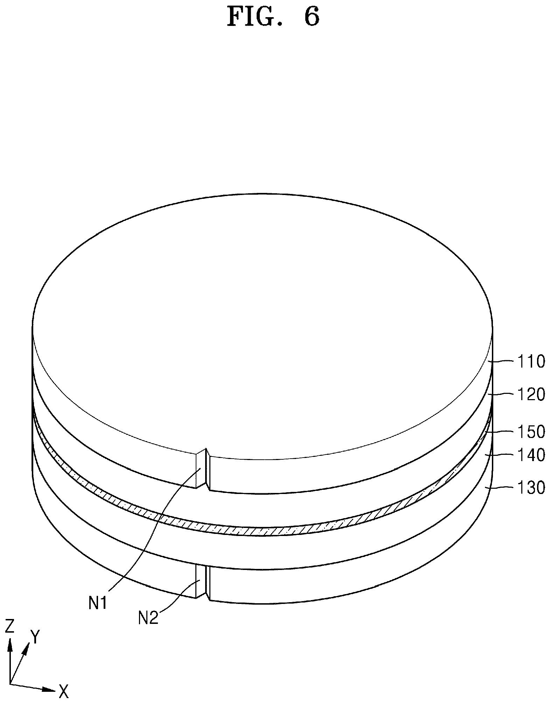

Referring to FIGS. 1 and 6, the cell wafer 110 may be bonded to the peripheral circuit wafer 130 such that the memory stack 120 and the peripheral circuit stack 140 come into contact with each other (S50). In the configuration shown in FIG. 6, the cell wafer 110 and the memory stack 120 are flipped in the vertical direction Z compared to the orientation in FIG. 3A. The cell wafer 110 may be bonded to the peripheral circuit wafer 130 such that the first notch N1 is aligned with the second notch N2. When bonded, the cell wafer 110 may have a different crystal orientation to the peripheral circuit wafer 130. After bonding, the first notch direction ND1 and the second notch direction ND2 may be aligned.

In some implementations, a bonding structure 150 may be further provided between the memory stack 120 and the peripheral circuit stack 140. For example, the bonding structure 150 may include an insulating layer and/or bonding pad. For example, the bonding structure 150 may include a bonding pad containing copper and an insulating layer containing oxide. In this case and other cases, the bonding structure 150 may bond the memory stack 120 and the peripheral circuit stack 140 to each other using a metal-oxide hybrid bonding method.

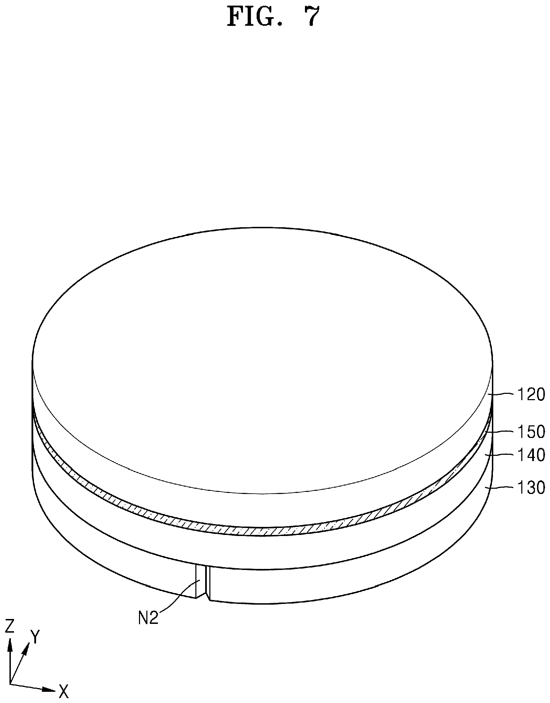

Referring to FIGS. 1 and 7, the cell wafer 110 may be selectively removed. In some implementations, the cell wafer 110 may be removed, and thus, the upper surface of the memory stack 120 may be exposed. A common source plate connected to the channel CH (see FIG. 3B), a passivation layer covering the common source plate, and an input/output via and/or input/output pad electrically connected to the common source plate may be further formed on the upper surface of the memory stack 120.

In some implementations, instead of completely removing the cell wafer 110, a portion of the cell wafer 110 may be removed. For example, the cell wafer 110 may be ground to reduce the thickness of the cell wafer 110.

The resulting semiconductor device shown in FIG. 7, obtained by performing the above-described processes, may be used for device operations, e.g., memory operations.

In cases in which both the cell wafer and the peripheral circuit wafer have the crystal orientation of {100}<100>, as the number of word lines formed on the cell wafer increases, the stress anisotropy may increase and warpage of the cell wafer may occur. Due to the increase in warpage of the cell wafer, breaking or chipping of the cell wafer may occur, process defects, such as pattern misalignment, may occur during the process of forming the memory stack, and/or bonding defects may occur during the process of bonding the cell wafer to the peripheral circuit wafer.

According to some implementations, the first crystal orientation of the cell wafer 110 includes one of {110}<100>, {110}<112>, {111}<110>, and {111}<112>, and the stress anisotropy of the memory stack 120 disposed on the cell wafer 110 may be significantly reduced. Accordingly, the occurrence of breaking or chipping of the cell wafer may be reduced, the occurrence of process defects, such as pattern misalignment, may be reduced during the process of forming the memory stack, and/or the occurrence of bonding defects may be reduced during the process of bonding the cell wafer to the peripheral circuit wafer.

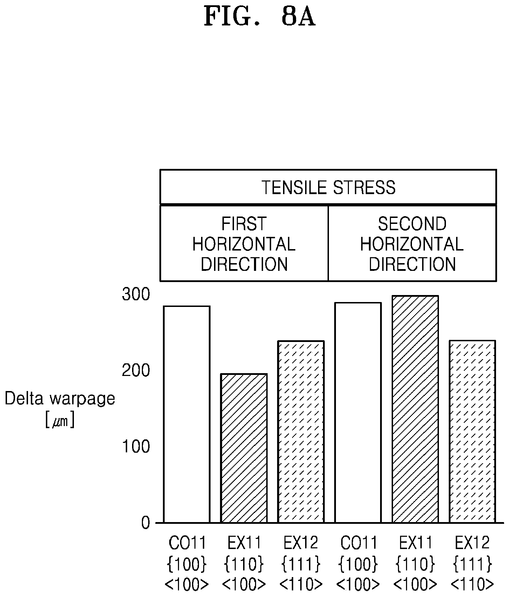

Hereinafter, warpage characteristics of semiconductor devices according to some implementations are described with reference to FIGS. 8A to 11B.

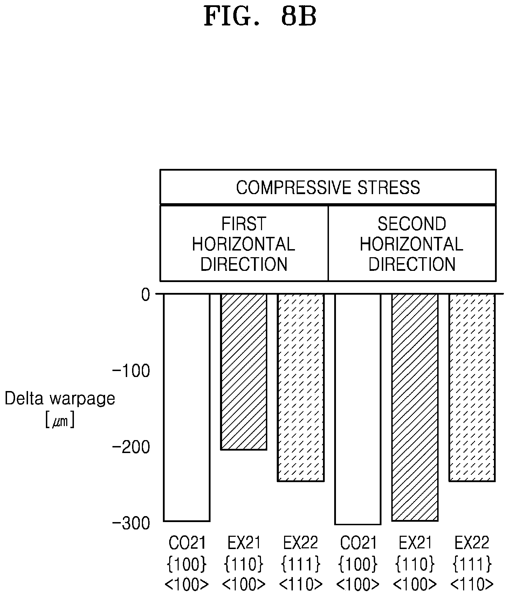

FIGS. 8A and 8B are graphs showing warpage characteristics depending on crystal orientations of a cell wafer according to some implementations.

FIG. 8A shows the results of measuring warpage values of a cell wafer (e.g., cell wafer 110) in a first horizontal direction and a second horizontal direction after forming a single film in a tensile stress state on the cell wafer. As used herein, the "single film in a tensile stress state" may refer to a single film in a state in which the cell wafer and the single film are bent such that a portion of the single film disposed on the edge of the cell wafer is at a higher vertical level than a portion of the single film disposed on the center of the cell wafer. For example, the "single film in a tensile stress state" may refer to a single film in a state in which the edge of the cell wafer and the edge of the single film are bent upward.

In FIG. 8A, Example 11 (EX1 1) represents a cell structure in which a single film in a tensile stress state is formed on a cell wafer having a first crystal orientation of {110}<100>. Example 12 (EX12) represents a cell structure in which a single film in a tensile stress state is formed on a cell wafer having a first crystal orientation of {111 } <110>. On the other hand, Comparative Example 11 (CO11) represents a cell structure in which a single film in a tensile stress state is formed on a cell wafer having a crystal orientation of {100}<100>.

Referring to FIGS. 8A, the warpage of Example 11 (EX1 1) in the first horizontal direction is reduced by 31.8 % compared to the warpage of Comparative Example 11 (CO11) in the first horizontal direction, and the warpage of Example 12 (EX12) in the first horizontal direction is reduced by 21.2 % compared to the warpage of Comparative Example 11 (CO11) in the first horizontal direction.

The warpage of Example 12 (EX12) in the second horizontal direction is reduced by approximately 21.2 % compared to the warpage of Comparative Example 11 (CO11) in the second horizontal direction. However, the warpage of Example 11 (EX11) in the second horizontal direction shows an approximately similar value to the warpage of Comparative Example 11 (CO 11) in the second horizontal direction.

FIG. 8B shows the results of measuring warpage values of a cell wafer in a first horizontal direction and a second horizontal direction after forming a single film in a compressive stress state on the cell wafer. As used herein, the "single film in a compressive stress state" may refer to a single film in a state in which the cell wafer and the single film are bent such that a portion of the single film disposed on the edge of the cell wafer is at a lower vertical level than a portion of the single film disposed on the center of the cell wafer. For example, the "single film in a compressive stress state" may refer to a single film in a state in which the edge of the cell wafer and the edge of the single film are bent downward.

In FIG. 8B, Example 21 (EX21) represents a cell structure in which a single film in a compressive stress state is formed on a cell wafer having a first crystal orientation of {110}<100>. Example 22 (EX22) represents a cell structure in which a single film in a compressive stress state is formed on a cell wafer having a first crystal orientation of {111}<110>. On the other hand, Comparative Example 21 (CO21) represents a cell structure in which a single film in a compressive stress state is formed on a cell wafer having a crystal orientation of {100}<100>.

Referring to FIGS. 8B, the warpage of Example 21 (EX21) in the first horizontal direction is reduced by 31.8 % compared to the warpage of Comparative Example 21 (CO21) in the first horizontal direction, and the warpage of Example 22 (EX22) in the first horizontal direction is reduced by 21.2 % compared to the warpage of Comparative Example 21 (CO21) in the first horizontal direction.

The warpage of Example 22 (EX22) in the second horizontal direction is reduced by approximately 21.2 % compared to the warpage of Comparative Example 21 (CO21) in the second horizontal direction. However, the warpage of Example 21 (EX21) in the second horizontal direction shows an approximately similar value to the warpage of Comparative Example 21 (CO21) in the second horizontal direction.

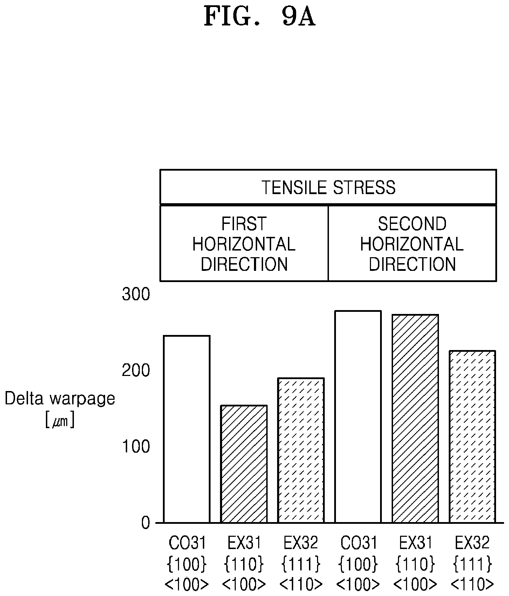

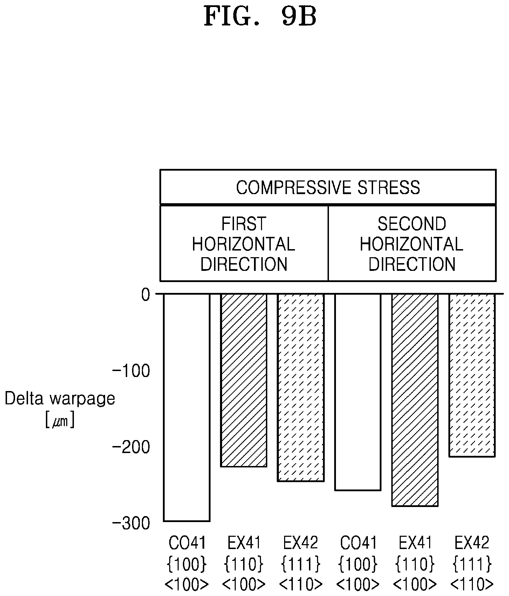

FIGS. 9A and 9B are graphs showing warpage characteristics depending on crystal orientations of a cell wafer according to some implementations.

FIG. 9A shows the results of measuring warpage values of a cell wafer in a first horizontal direction and a second horizontal direction after forming a memory stack (e.g., memory stack 120) in a tensile stress state on the cell wafer (e.g., cell wafer 110). As used herein, the "memory stack in a tensile stress state" may refer to a memory stack in a state in which the cell wafer and the memory stack are bent such that a portion of the memory stack disposed on the edge of the cell wafer is at a higher vertical level than a portion of the memory stack disposed on the center of the cell wafer. For example, the "memory stack in a tensile stress state" may refer to a memory stack in a state in which the edge of the cell wafer and the edge of the memory stack are bent upward.

In FIG. 9A, Example 31 (EX31) represents a cell structure in which a memory stack including a plurality of word lines, a plurality of channel structures, and a plurality of bit lines is formed on a cell wafer having a first crystal orientation of {110}<100>, wherein the memory stack is in a tensile stress state. Also, the plurality of word lines extend in the first horizontal direction and the plurality of channel structures extend in the vertical direction. Example 32 (EX32) represents a cell structure in which a memory stack including a plurality of word lines, a plurality of channel structures, and a plurality of bit lines is formed on a cell wafer having a first crystal orientation of {111} <110>, wherein the memory stack is in a tensile stress state. On the other hand, Comparative Example 31 (CO31) represents a cell structure in which a memory stack including a plurality of word lines, a plurality of channel structures, and a plurality of bit lines is formed on a cell wafer having a crystal orientation of {100}<100>, wherein the memory stack is in a tensile stress state.

Referring to FIG. 9A, the warpage of Example 31 (EX31) and Example 32 (EX32) in the first horizontal direction show similar values to the warpage of Example 11 (EX11) and Example 12 (EX12) of FIG. 8A in the first horizontal direction. For example, the warpage of Example 31 (EX31) in the first horizontal direction is reduced by approximately 30 % compared to the warpage of Comparative Example 31 (CO31) in the first horizontal direction, and the warpage of Example 32 (EX32) in the first horizontal direction is reduced by approximately 20 % compared to the warpage of Comparative Example 31 (CO31) in the first horizontal direction.

The warpage of Example 32 (EX32) in the second horizontal direction is reduced by approximately 20 % compared to the warpage of Comparative Example 31 (CO31) in the second horizontal direction. However, the warpage of Example 31 (EX31) in the second horizontal direction shows an approximately similar value to the warpage of Comparative Example 31 (CO31) in the second horizontal direction.

FIG. 9B shows the results of measuring warpage values of a cell wafer in a first horizontal direction and a second horizontal direction after forming a memory stack in a compressive stress state on the cell wafer. As used herein, the "memory stack in a compressive stress state" may refer to a memory stack in a state in which the cell wafer and the memory stack are bent such that a portion of the memory stack disposed on the edge of the cell wafer is at a lower vertical level than a portion of the memory stack disposed on the center of the cell wafer. For example, the "memory stack in a compressive stress state" may refer to a memory stack in a state in which the edge of the cell wafer and the edge of the memory stack are bent downward.

In FIG. 9B, Example 41 (EX41) represents a cell structure in which a memory stack including a plurality of word lines, a plurality of channel structures, and a plurality of bit lines is formed on a cell wafer having a first crystal orientation of {110}<100>, wherein the memory stack is in a compressive stress state. Also, the plurality of word lines extend in the first horizontal direction and the plurality of channel structures extend in the vertical direction. Example 42 (EX42) represents a cell structure in which a memory stack including a plurality of word lines, a plurality of channel structures, and a plurality of bit lines is formed on a cell wafer having a first crystal orientation of {111} <110>, wherein the memory stack is in a compressive stress state. On the other hand, Comparative Example 41 (CO41) represents a cell structure in which a memory stack including a plurality of word lines, a plurality of channel structures, and a plurality of bit lines is formed on a cell wafer having a crystal orientation of {100}<100>, wherein the memory stack is in a compressive stress state.

Referring to FIG. 9B, the warpage of Example 41 (EX41) in the first horizontal direction is reduced by approximately 30 % compared to the warpage of Comparative Example 41 (CO41) in the first horizontal direction, and the warpage of Example 42 (EX42) in the first horizontal direction is reduced by approximately 20 % compared to the warpage of Comparative Example 41 (CO41) in the first horizontal direction.

The warpage of Example 42 (EX42) in the second horizontal direction is reduced by approximately 20 % compared to the warpage of Comparative Example 41 (CO41) in the second horizontal direction. However, the warpage of Example 41 (EX41) in the second horizontal direction shows a slightly greater value than the warpage of Comparative Example 41 (CO41) in the second horizontal direction.

Based on the measurement values of warpage obtained from the graphs shown in FIGS. 8A, 8B, 9A, and 9B, it can be seen that the cell wafers according to some implementations, that is, Examples 11, 21, 31, and 41 (EX11, EX21, EX31, and EX41) having the crystal orientation of {110}<100> and Examples 12, 22, 32, and 42 (EX12, EX22, EX32, and EX42) having the crystal orientation of {111}<110> all have significantly reduced warpage values compared to Comparative Examples 11, 21, 31, and 41 (CO11, CO21, CO31, and CO41) for at least one direction.

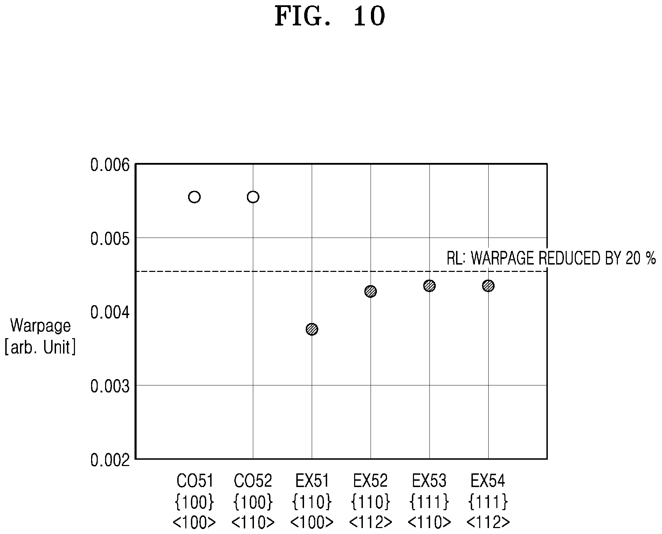

FIG. 10 is a graph of simulation results of warpage values depending on the crystal orientations of the cell wafer.

In FIG. 10, the theoretical warpage values are calculated using the Stoney equation, using moduli in the X, Y, and Z directions and Poisson's ratios in the X, Y, and Z directions depending on the crystal orientations of the cell wafer. FIG. 10 shows the theoretical warpage values calculated in a first horizontal direction and a second horizontal direction, with respect to a cell wafer on which a memory stack is formed. Example 51 (EX51), Example 52 (EX52), Example 53 (EX53), and Example 54 (EX54) represent single crystal silicon wafers having crystal orientations of {110}<100>, {110}<112>, {111}<110>, and {111}<112>, respectively. Comparative Example 51 (CO51) represents a single crystal silicon wafer having a crystal orientation of {100}<100>, and Comparative Example 52 (CO52) represents a single crystal silicon wafer having a crystal orientation of {100} <110>.

Referring to FIG. 10, Example 51 (EX51), Example 52 (EX52), Example 53 (EX53), and Example 54 (EX54) show warpage reduced by 20% or by more than 20% compared to Comparative Example 51 (CO51) and Comparative Example 52 (CO52). A reference line RL shown in FIG. 10 represents a point having a warpage value reduced by 20% from the warpage value of Comparative Example 51 (CO51), that is, a warpage value corresponding to 80 % of the warpage value of Comparative Example 51 (CO51). Example 51 (EX51), Example 52 (EX52), Example 53 (EX53), and Example 54 (EX54) all show the warpage values lower than the reference line RL, and it can be seen that all of Examples 51 to 54 have significantly reduced warpage values compared to Comparative Example 51 (CO51) and Comparative Example 52 (CO52).

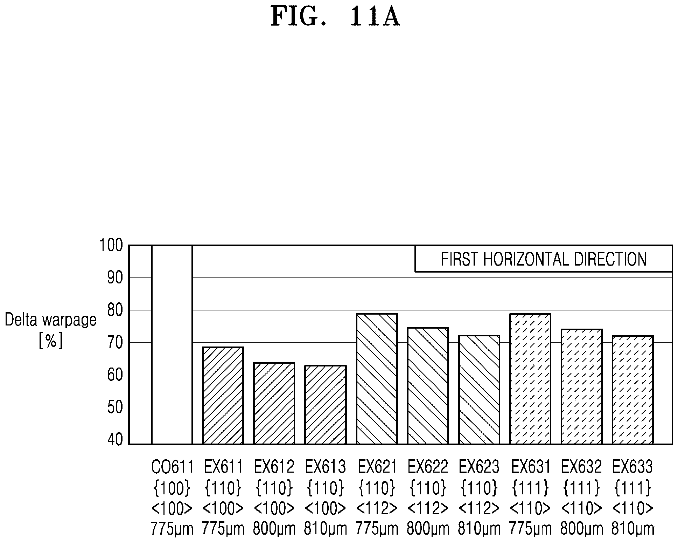

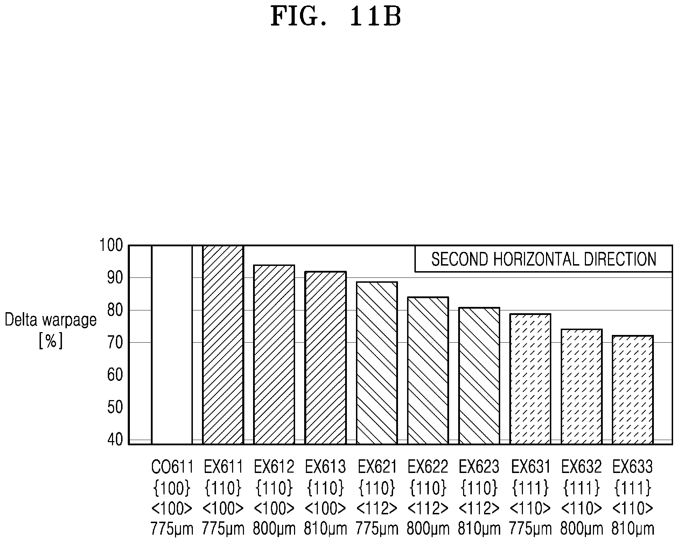

FIGS. 11A and 11B are graphs showing warpage characteristics depending on thicknesses of the cell wafer.

FIG. 11A shows warpage values of cell wafers having various crystal orientations in a first horizontal direction, which are normalized based on a warpage value of Comparative Example 611 (CO611). FIG. 11B shows warpage values of cell wafers having various crystal orientations in a second horizontal direction, which are normalized based on a warpage value of Comparative Example 611 (CO611). FIGS. 11A and 11B show the warpage values calculated in a first horizontal direction and a second horizontal direction, with respect to cell wafers on which memory stacks are formed.

The crystal orientations and the thicknesses of cell wafers of Examples 611 to 633 (EX611 to EX633) and Comparative Example 611 (CO611) are shown in Table 1 below.

**[Table 1]**

| Classification | Crystal orientation | Thickness of cell wafer |
|---|---|---|
| Comparative example 611 (CO611) | {100}<100> | 775 µm |
| Example 611 (EX611) | {110}<100> | 775 µm |
| Example 612 (EX612) | {110}<100> | 800 µm |
| Example 613 (EX613) | {110}<100> | 810 µm |
| Example 621 (EX621) | {110}<112> | 775 µm |
| Example 622 (EX622) | {110}<112> | 800 µm |
| Example 623 (EX623) | {110}<112> | 810 µm |
| Example 631 (EX631) | {111}<110> | 775 µm |
| Example 632 (EX632) | {111}<110> | 800 µm |
| Example 633 (EX633) | {111}<110> | 810 µm |

Referring to FIGS. 11A and 11B, Example 611 (EX611), Example 612 (EX612), and Example 613 (EX613) all have the same crystal orientation of {110}<100> but have different cell wafer thicknesses of 775 µm, 800 µm, and 810 µm, respectively. Example 611 (EX611), Example 612 (EX612), and Example 613 (EX613) all show significantly reduced warpage values in the first horizontal direction compared to Comparative example 611 (CO611) (e.g., warpage values in the range of about 60 % to about 70 % of the warpage of Comparative example 611 (CO611)). Also, for cell wafers having the same crystal orientation, it can be seen that the warpage value is further reduced as the thickness of the cell wafer increases.

As described with reference to FIGS. 8A to 11B, the cell wafers according to some implementations may have thicknesses of about 775 µm to 810 µm and crystal orientations of {110}<100>, {110}<112>, {111}<110>, and {111}<112>. Accordingly, it can be seen that the cell wafers have significantly reduced warpage values compared to the cell wafer having the crystal orientation of {100}<100> or {100}<110> according to the Comparative Examples.

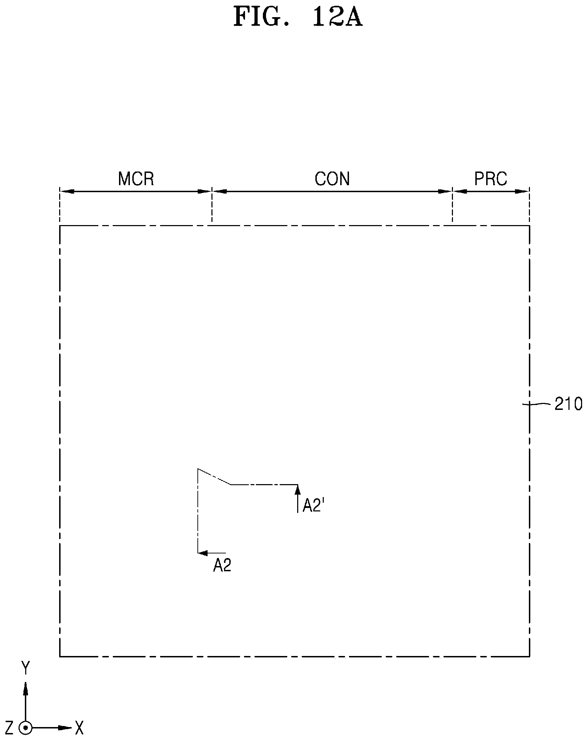

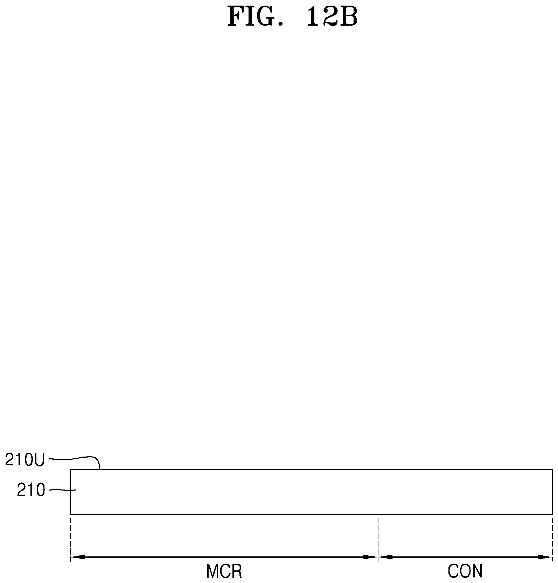

FIGS. 12A, 12B, 13A, 13B, 14A, 14B, and 15 to 20 are schematic views showing a method of manufacturing a semiconductor device 100, according to some implementations. FIGS. 12B, 13B, and 14B show cross-sectional views along lines A2-A2' of FIGS. 12A, 13A, and 14A, respectively.

Referring to FIGS. 12A and 12B, a cell wafer 210 may be provided. The cell wafer 210 may include a cell region MCR, a connection region CON, and a peripheral circuit connection region PRC. The cell region MCR may include a region in which a memory cell block including a plurality of memory cell strings extending in a vertical direction Z is provided, the connection region CON may include a region in which an electrical connection for a word line of each of the memory cell strings is provided, and the peripheral circuit connection region PRC may include a region in which an electrical connection component for connecting the memory cell block to a peripheral circuit is provided.

In some implementations, the cell wafer 210 may include at least one of silicon (Si), germanium (Ge), and silicon germanium (SiGe). The cell wafer 210 may include the cell wafer 110 described with reference to FIGS. 2A and 2B.

The cell wafer 210 may have a first crystal orientation, and the first crystal orientation may be defined by a first surface orientation and a first notch direction. The first crystal orientation may be expressed as {first surface orientation} <first notch direction>. In some implementations, the first crystal orientation of the cell wafer 210 may include any one of {110}<100>, {110}<112>, {111}<110>, and {111}<112>. Also, the cell wafer 210 may have a thickness of about 750 micrometers to about 840 micrometers.

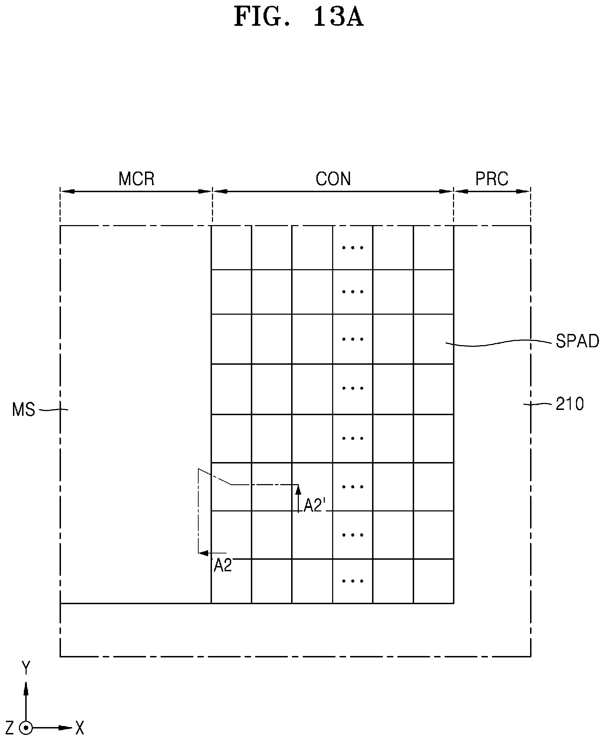

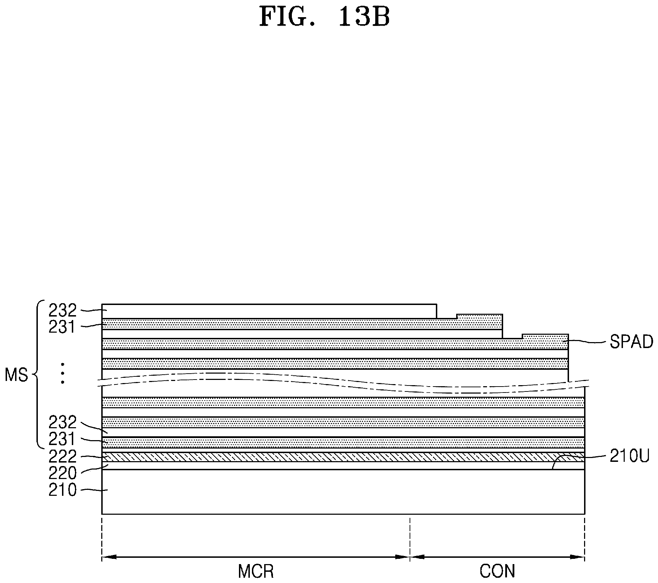

Referring to FIGS. 13A and 13B, a buffer insulating layer 220 may be formed on an upper surface 210U of the cell wafer 210 and an etch stop layer 222 may be formed on the buffer insulating layer 220.

The buffer insulating layer 220 may be formed using silicon oxide. In some implementations, the etch stop layer 222 may be formed using polysilicon.

Subsequently, in the cell region MCR and the connection region CON, a mold stack MS alternately including sacrificial layers 231 and mold insulating layers 232 may be formed on the etch stop layer 222. The sacrificial layers 231 and the mold insulating layers 232 may be formed using materials having etch selectivity with respect to each other (or having different etch rates).

Subsequently, a preliminary pad SPAD may be formed by patterning portions of the mold stack MS in the connection region CON. The preliminary pad SPAD may be formed in a step shape and have a greater thickness than each of the sacrificial layers 231.

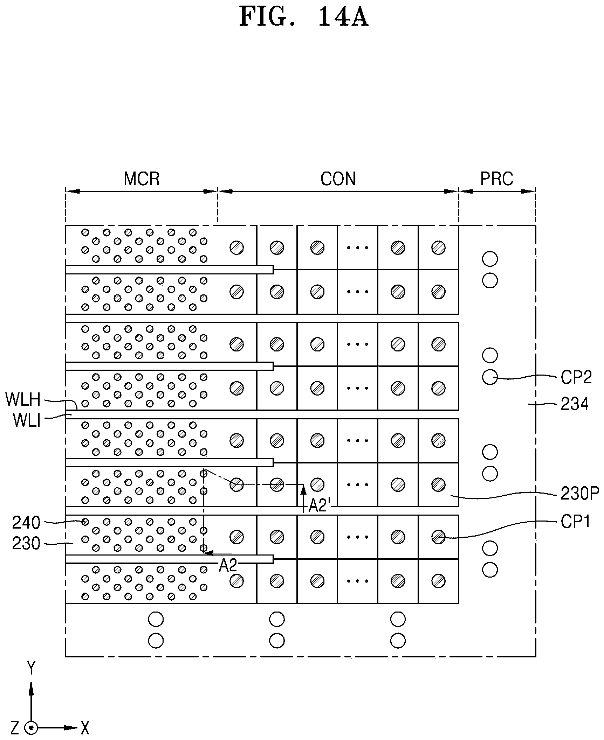

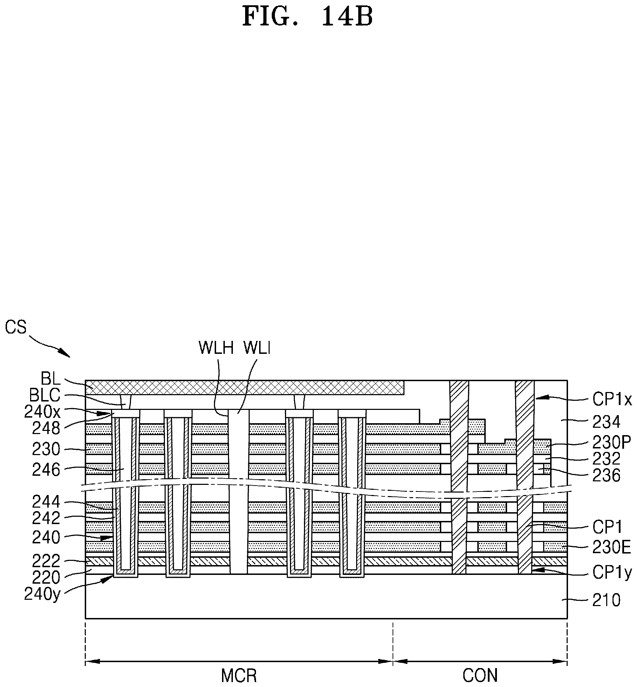

Referring to FIGS. 14A and 14B, a channel structure 240 extending in the vertical direction Z through the mold stack MS may be formed in the cell region MCR. The channel structure 240 may be located inside a channel hole extending in the vertical direction Z through the mold stack MS and include a gate insulating layer 242, a channel layer 244, an insulating liner 246, and a drain region 248. A first end 240x of the channel structure 240 may be at a higher vertical level than a second end 240y of the channel structure 240, and the second end 240y may pass through the etch stop layer 222 and extend into the cell wafer 210.

Subsequently, a stack isolation opening WLH extending through the mold stack MS in a first horizontal direction X may be formed, and the sacrificial layer 231 and the preliminary pad SPAD exposed on the inner wall of the stack isolation opening WLH may be removed. Subsequently, a gate electrode 230 and a pad 230P may be respectively formed in spaces from which the sacrificial layer 231 and the preliminary pad SPAD have been removed. Also, a portion of the gate electrode 230 located in the connection region CON may be referred to as an extension 230E. Subsequently, a stack isolation insulating layer WLI may be formed inside the stack isolation opening WLH.

Subsequently, a stack insulating layer 234 may be formed covering the gate electrode 230 and the pad 230P, and a bit line BL connected to the channel structure 240 may be formed on the stack insulating layer 234.

Also, a first plug CP1 passing through the extensions 230E and the pad 230P may be formed in the connection region CON, and a second plug CP2 passing through the stack insulating layer 234 may be formed in the peripheral circuit connection region PRC. A first end CP1x of the first plug CP1 may have a greater width than a second end CP1y of the first plug CP1, and the first plug CP1 may have a sufficient height such that the second end CP1y extends into the cell wafer 210 through the etch stop layer 222.

In some implementations, a first plug hole passing through the mold stack MS may be formed in a connection region CON, a portion of the sacrificial layer 231 exposed on the sidewall of the first plug hole may be removed by lateral etching, and an insulating pattern 236 may be formed in a region from which the sacrificial layer 231 has been removed. Subsequently, the first plug CP1 may be formed in the first plug hole.

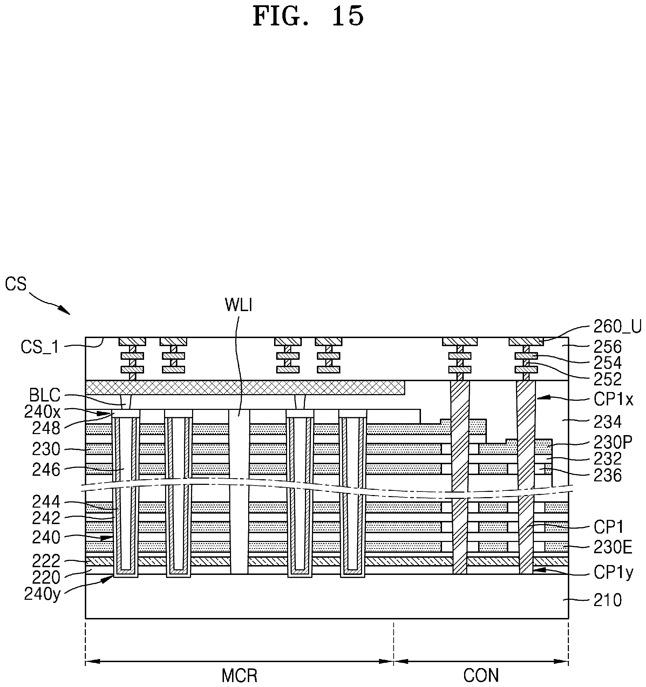

Referring to FIG. 15, a connection via 252, electrically connected to the bit line BL and the first plug CP1, a connection wiring layer 254, and an interlayer insulating film 256 may be formed. A connection pad 260_U may be formed on the upper surface of the interlayer insulating film 256.

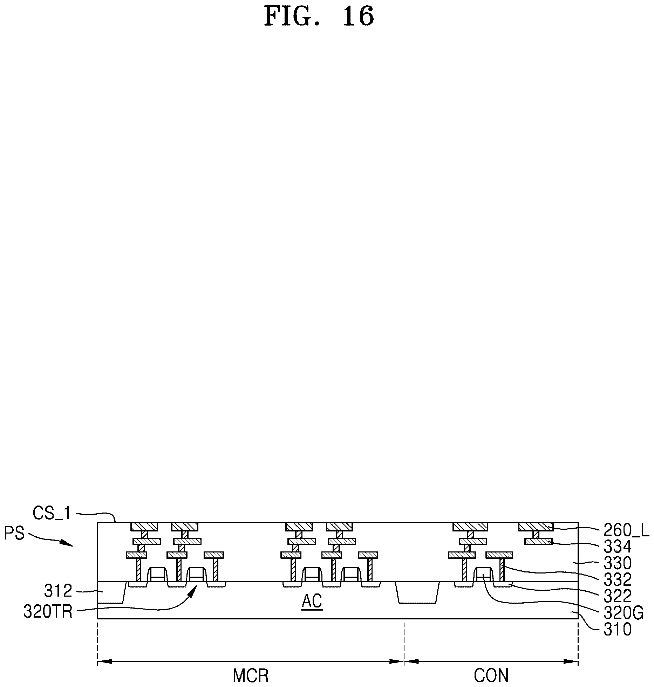

Referring to FIG. 16, a peripheral circuit structure PS may be prepared. The peripheral circuit structure PS may include a peripheral circuit transistor 320TR, disposed on a peripheral circuit wafer 310, a plurality of peripheral circuit contacts 332, a plurality of peripheral circuit wiring layers 334, and an interlayer insulating film 330.

The peripheral circuit wafer 310 may include at least one of silicon (Si), germanium (Ge), and silicon germanium (SiGe). The peripheral circuit wafer 310 may include the peripheral circuit wafer 130 described with reference to FIGS. 4A and 4B.

The peripheral circuit wafer 310 may have a second crystal orientation, and the second crystal orientation may be defined by a second surface orientation and a second notch direction. The second crystal orientation may be expressed as {second surface orientation}<second notch direction>. In some implementations, the second crystal orientation of the peripheral circuit wafer 310 may include {100}<100> or {100}<110>.

An active region AC may be defined in the peripheral circuit wafer 310 by a device isolation film 312, and a plurality of peripheral circuit transistors 320TR may be formed on the active region AC. Each of the plurality of peripheral circuit transistors 320TR may include a peripheral circuit gate 320G and source/drain regions 322 arranged in portions of the peripheral circuit wafer 310 on both sides of the peripheral circuit gate 320G.

The plurality of peripheral circuit contacts 332 and the plurality of peripheral circuit wiring layers 334 may be electrically connected to the peripheral circuit transistor 320TR on the peripheral circuit wafer 310. Also, the interlayer insulating film 330 covering the peripheral circuit transistor 320TR, the plurality of peripheral circuit contacts 332, and the plurality of peripheral circuit wiring layers 334 may be disposed on the peripheral circuit wafer 310. The plurality of peripheral circuit wiring layers 334 may have a multilayer structure including a plurality of metal layers arranged at different vertical levels. A connection pad 260_L may be disposed on the uppermost surface CS_1 of the peripheral circuit structure PS.

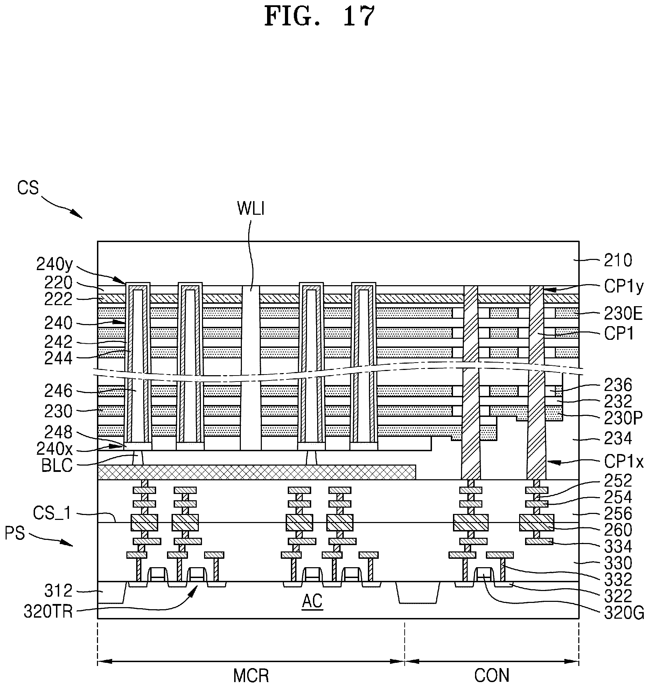

Referring to FIG. 17, the peripheral circuit structure PS may be attached to a cell structure CS, e.g., the cell structure CS shown in FIG. 15. The peripheral circuit structure PS and the cell structure CS may be attached to each other, through a connection pad 260 and interlayer insulating films 330 and 256, by using a metal-oxide hybrid bonding method.

According to some implementations, the first crystal orientation of the cell wafer 210 may include one of {110}<100>, {110}<112>, {111}<110>, and {111}<112>, and the occurrence of warpage of the cell wafer 210 due to stress anisotropy (e.g., the stress anisotropy occurring as the number of gate electrodes 230 in the vertical direction increases) of the cell structure CS disposed on the cell wafer 210 may be significantly reduced. Accordingly, the occurrence of bonding defects during the process of bonding the cell wafer 210 to the peripheral circuit wafer 310 may be reduced.

Subsequently, the structure in which the peripheral circuit structure PS and the cell structure CS are attached to each other may be turned over so that the cell wafer 210 faces upward as shown in FIG. 17.

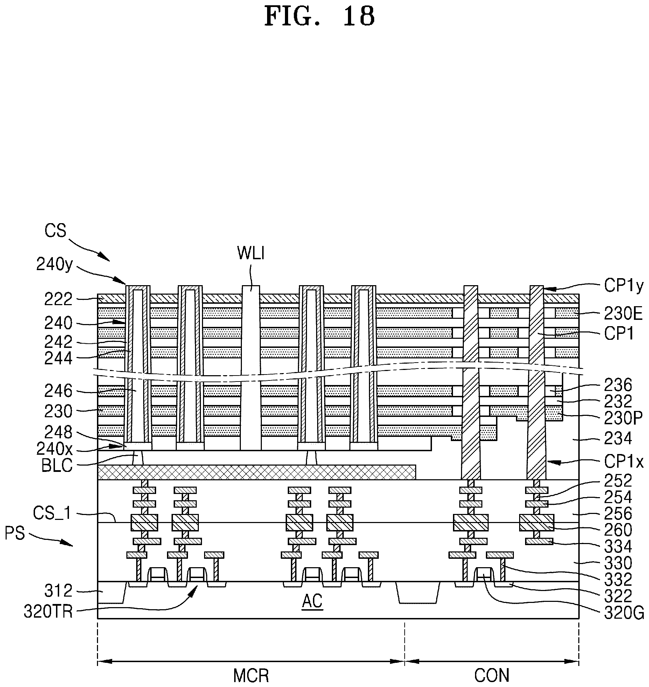

Referring to FIG. 18, the cell wafer 210 may be removed. The cell wafer 210 may be removed by a grinding process and a subsequent etching process, and the buffer insulating layer 220 (see FIG. 17) may be exposed.

Then, the buffer insulating layer 220 may also be removed, and the upper surface of the etch stop layer 222 may be exposed. As the buffer insulating layer 220 is removed, the second end 240y of the channel structure 240 and the second end CP1y of the first plug CP1 may protrude from the upper surface of the etch stop layer 222.

As the cell wafer 210 and the buffer insulating layer 220 are removed, the upper side of the stack isolation insulating layer WLI may also be exposed and protrude above the etch stop layer 222.

Subsequently, a portion of the gate insulating layer 242 exposed at the second end 240y of the channel structure 240 may be removed, and thus, the upper surface of the channel layer 244 may be exposed. When the gate insulating layer 242 is removed, a process of removing the gate insulating layer 242 may be performed so that the upper surface of the etch stop layer 222 is exposed. In some implementations, the upper portion of the gate insulating layer 242 may be removed such that the gate insulating layer 242 becomes at a lower level than the upper surface of the channel layer 244, and thus, the upper surface and a portion of the sidewall of the channel layer 244 may be exposed.

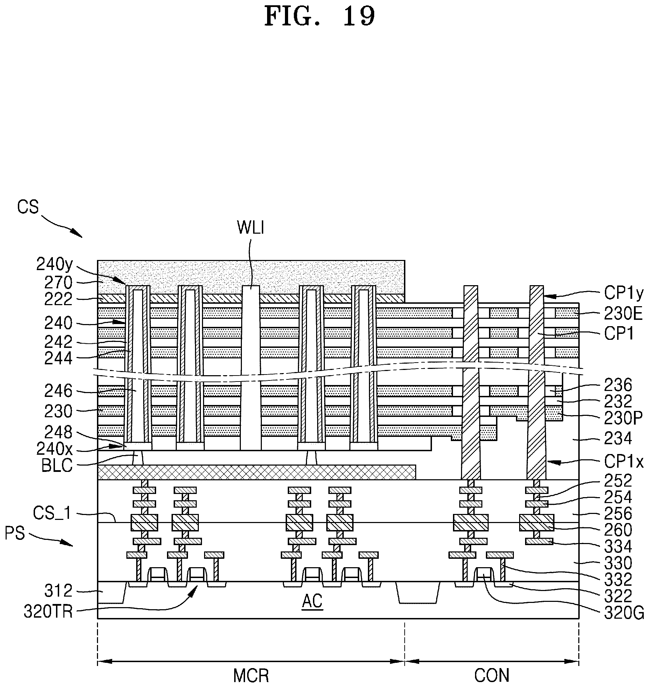

Referring to FIG. 19, a common source layer 270 may be formed in the cell region MCR, the connection region CON, and the peripheral circuit connection region PRC. The common source layer 270 may be formed using polysilicon. For example, the common source layer 270 may be formed using polysilicon doped with n-type impurities. In the cell region MCR, the common source layer 270 may be conformally formed on the exposed upper surfaces of the etch stop layer 222 and the channel layer 244.

Subsequently, a portion of the common source layer 270 and a portion of the etch stop layer 222, which are located in the connection region CON and the peripheral circuit connection region PRC, may be removed.

In some implementations, a mask pattern may be formed on the common source layer 270 in the cell region MCR, and the portion of the common source layer 270 and the portion of the etch stop layer 222, which are located in the connection region CON and the peripheral circuit connection region PRC, may be removed by using the mask pattern as an etch mask.

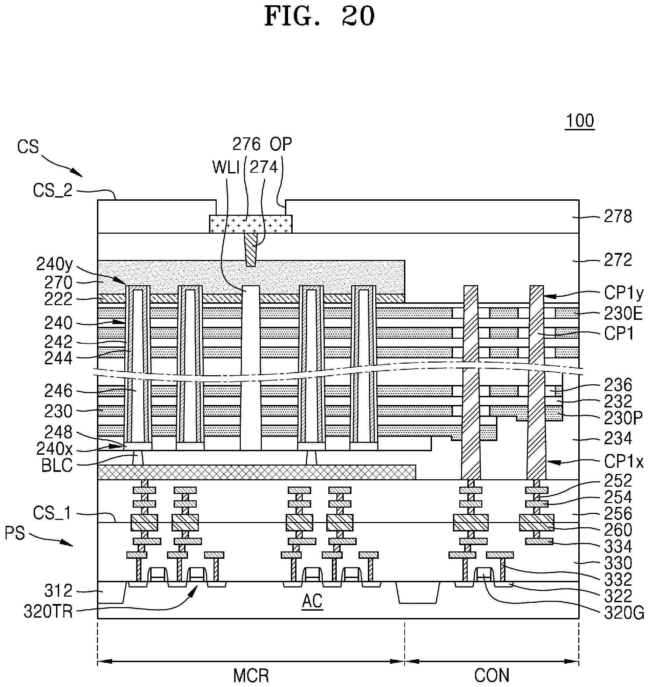

Referring to FIG. 20, in the cell region MCR, the connection region CON, and the peripheral circuit connection region PRC, an upper insulating layer 272 may be formed on the common source layer 270 and the uppermost mold insulating layer among the mold insulating layers 232. The upper insulating layer 272 may have a height sufficient to cover both the common source layer 270 and the second end CP1y of the first plug CP1 and form a flat upper level.

Subsequently, a mask pattern may be formed on the upper insulating layer 272, and a rear contact hole may be formed by removing a portion of the upper insulating layer 272 using the mask pattern as an etch mask. A common source contact 274 may be formed inside the rear contact hole, and a rear wiring layer 276 electrically connected to the common source contact 274 may be formed on the upper insulating layer 272.

Subsequently, a passivation layer 278 covering the rear wiring layer 276 may be formed on the upper insulating layer 272, and an opening OP may be formed through the passivation layer 278, from an upper surface CS_2 to expose the upper surface of the rear wiring layer 276.

The resulting semiconductor device 100 manufactured by performing the above-described processes can then be used, e.g., for memory operations.

In cases in which both the cell wafer and the peripheral circuit wafer have the crystal orientation of {100}<100>, as the number of word lines formed on the cell wafer increases, the stress anisotropy increases and the warpage of the cell wafer may occur. Due to the increase in warpage of the cell wafer, breaking or chipping of the cell wafer may occur, process defects, such as pattern misalignment, may occur during the process of forming the memory stack, and/or bonding defects may occur during the process of bonding the cell wafer to the peripheral circuit wafer.

According to some implementations, the first crystal orientation of the cell wafer 210 may include one of {110}<100>, {110}<112>, {111}<110>, and {111}<112>, and the stress anisotropy (e.g., the stress anisotropy occurring as the number of gate electrodes 230 in the vertical direction increases) of the cell structure CS disposed on the cell wafer 210 may be significantly reduced. Accordingly, the occurrence of breaking or chipping of the cell wafer 210 may be reduced, the occurrence of process defects, such as pattern misalignment, may be reduced during the process of forming the cell structure CS, or the occurrence of bonding defects may be reduced during the process of bonding the cell wafer 210 to the peripheral circuit wafer 310.

FIGS. 12A to 20 illustrate examples in which the cell structure CS includes flash memory cells arranged in three dimensions. In some implementations, the cell structure CS may include a plurality of variable-resistance memory cells arranged in the vertical direction Z. In some implementations, the cell structure CS may include a plurality of phase-change memory cells arranged in the vertical direction Z or a plurality of ferroelectric memory cells arranged in the vertical direction Z.

Also, FIGS. 18 and 19 illustrate a manufacturing method in which the cell wafer 210 is removed and then the common source layer 270 connected to the channel structure 240 is formed. In some implementations, the upper portion of the cell wafer 210 may be ground so that the cell wafer 210 is not completely removed and a thin cell wafer 210 remains. In this case, a certain portion of the cell wafer 210 having the reduced thickness may function as a common source region connected to the channel structure 240. Also, a passivation layer, an input/output pad, or the like may be further formed on the upper surface of the cell wafer 210 having the reduced thickness.

The present application discusses crystal planes and crystal directions based on Miller indices. It will be appreciated that certain planes are equivalent due to symmetry within the lattice. In addition, certain directions are equivalent due to symmetry within the lattice. Accordingly, symmetrically equivalent planes/directions may also be used. For instance, the notation {hkl} may represent the set of all planes that are equivalent to the plane (hkl) by symmetry of the lattice (where h, k, and l are Miller indices). Similarly, the notation <hkl> may represent the set of all directions that are equivalent to the direction [hkl] by symmetry of the lattice.

While this specification contains many specific implementation details, these should not be construed as limitations on the scope of any invention or on the scope of what may be claimed, but rather as descriptions of features that may be specific to particular implementations of particular inventions. Certain features that are described in this specification in the context of separate implementations can also be implemented in combination in a single implementation. Conversely, various features that are described in the context of a single implementation can also be implemented in multiple implementations separately or in any suitable subcombination. Moreover, although features may be described above as acting in certain combinations, one or more features from a combination can in some cases be excised from the combination, and the combination may be directed to a subcombination or variation of a subcombination.

Embodiments are set out in the following Clauses:
Clause 1. A method of manufacturing a semiconductor device, the method comprising:
   forming a memory stack on a cell wafer, wherein the cell wafer has a first crystal orientation and comprises a first silicon single crystal wafer, a first upper surface, and a first notch extending from an outer circumference of the cell wafer toward a central region of the cell wafer;
   forming a peripheral circuit stack on a peripheral circuit wafer, wherein the peripheral circuit wafer has a second crystal orientation different from the first crystal orientation and comprises a second silicon single crystal wafer, a second upper surface, and a second notch extending from an outer circumference of the peripheral circuit wafer toward a central region of the peripheral circuit wafer; and
   bonding the cell wafer to the peripheral circuit wafer such that the memory stack and the peripheral circuit stack contact one another,
   wherein the first crystal orientation is defined by a first surface orientation and a first notch direction, wherein the first surface orientation is defined in a direction perpendicular to the first upper surface of the cell wafer, and the first notch direction is defined based on a direction from the central region of the cell wafer toward the first notch of the cell wafer,
   wherein the first crystal orientation is expressed as {the first surface orientation}<the first notch direction>,
   wherein the first crystal orientation comprises {110}<100> or {110}<112>,
   wherein the second crystal orientation is defined by a second surface orientation and a second notch direction, wherein the second surface orientation is defined in a direction perpendicular to the second upper surface of the peripheral circuit wafer, and the second notch direction is defined based on a direction from the central region of the peripheral circuit wafer toward the second notch of the peripheral circuit wafer,
   wherein the second crystal orientation is expressed as {the second surface orientation}<the second notch direction>, and
   wherein the second crystal orientation comprises {100}<100> or {100}<110>.
Clause 2. The method of Clause 1, wherein the memory stack comprises:
   a plurality of gate electrodes disposed on the cell wafer, extending in a first horizontal direction, and spaced apart from each other in a vertical direction;
   a plurality of channels each extending in the vertical direction and passing through the plurality of gate electrodes; and
   a plurality of bit lines respectively connected to the plurality of channels and extending in a second horizontal direction,
   wherein the peripheral circuit stack comprises a peripheral circuit disposed on the peripheral circuit wafer, and
   wherein the first notch direction is parallel to the second horizontal direction and the second notch direction is parallel to the second horizontal direction.
Clause 3. The method of Clause 2, wherein the memory stack comprises a first bonding pad electrically connected to the plurality of bit lines, and
   wherein the peripheral circuit stack comprises a second bonding pad electrically connected to the peripheral circuit and bonded to the first bonding pad.
Clause 4. The method of any preceding Clause, further comprising, after bonding the cell wafer to the peripheral circuit wafer, removing the cell wafer.
Clause 5. The method of Clause 4, further comprising:
   after removing the cell wafer, forming, on an upper surface of the memory stack, a common source plate connected to ends of the plurality of channels; and
   forming an input/output pad electrically connected to the common source plate.
Clause 6. The method of any preceding Clause, wherein the cell wafer has a thickness of 750 micrometers to 840 micrometers, and
   wherein the peripheral circuit wafer has a thickness of 750 micrometers to 840 micrometers.

While various examples have been particularly shown and described, it will be understood that various changes in form and details may be made therein without departing from the scope of the following claims.

## Claims

1. A method of manufacturing a semiconductor device, the method comprising:
forming a memory stack on a cell wafer, wherein the cell wafer has a first crystal orientation and comprises a first silicon single crystal wafer, a first upper surface, and a first notch extending from an outer circumference of the cell wafer toward a central region of the cell wafer;
forming a peripheral circuit stack on a peripheral circuit wafer, wherein the peripheral circuit wafer comprises a second silicon single crystal wafer and has a second crystal orientation different from the first crystal orientation; and
bonding the cell wafer to the peripheral circuit wafer such that the memory stack and the peripheral circuit stack contact one another,
wherein the first crystal orientation is defined by a first surface orientation and a first notch direction, wherein the first surface orientation is defined in a direction perpendicular to the first upper surface of the cell wafer, and the first notch direction is defined based on a direction from the central region of the cell wafer toward the first notch of the cell wafer,
wherein the first crystal orientation is expressed as {the first surface orientation}<the first notch direction>, and
wherein the first crystal orientation comprises {110}<100>, {110}<112>, {111}<110>, or {111}<112>.

2. The method of claim 1, wherein the peripheral circuit wafer comprises a second upper surface and a second notch extending from an outer circumference of the peripheral circuit wafer toward a central region of the peripheral circuit wafer, and
wherein the second crystal orientation is defined by a second surface orientation and a second notch direction, wherein the second surface orientation is defined in a direction perpendicular to the second upper surface of the peripheral circuit wafer, and the second notch direction is defined based on a direction from the central region of the peripheral circuit wafer toward the second notch of the peripheral circuit wafer,
wherein the second crystal orientation is expressed as {the second surface orientation}<the second notch direction>, and
wherein the second crystal orientation comprises {100}<100> or {100}<110>.

3. The method of claim 1 or claim 2, wherein the memory stack comprises:
a plurality of gate electrodes disposed on the cell wafer, extending in a first horizontal direction, and spaced apart from each other in a vertical direction;
a plurality of channels each extending in the vertical direction and passing through the plurality of gate electrodes; and
a plurality of bit lines respectively connected to the plurality of channels and extending in a second horizontal direction,
wherein the first notch direction is parallel to the second horizontal direction.

4. The method of claim 3, when dependent on claim 2, wherein the peripheral circuit stack comprises a peripheral circuit disposed on the peripheral circuit wafer,
wherein the second notch direction is parallel to the second horizontal direction.

5. The method of claim 3 or claim 4, wherein the memory stack comprises a first bonding pad electrically connected to the plurality of bit lines, and
wherein the peripheral circuit stack further comprises a second bonding pad electrically connected to the peripheral circuit and bonded to the first bonding pad.

6. The method of any preceding claim, wherein the cell wafer has a thickness of 750 micrometers to 840 micrometers, and
wherein the peripheral circuit wafer has a thickness of 750 micrometers to 840 micrometers.

7. The method of any preceding claim, further comprising, after bonding the cell wafer to the peripheral circuit wafer, removing the cell wafer.

8. The method of claim 7, further comprising, after removing the cell wafer:
forming a common source plate on an upper surface of the memory stack; and
forming an input/output pad electrically connected to the common source plate.

9. The method of any of claims 1-6, further comprising, after bonding the cell wafer to the peripheral circuit wafer, grinding the cell wafer to reduce a thickness of the cell wafer.

10. The method of any preceding claim, wherein the first crystal orientation comprises {110}<100> or {110}<112>.
